Europäisches Patentamt

European Patent Office

Office européen des brevets

(11) Publication number: **0 320 469**
A2

## (12) EUROPEAN PATENT APPLICATION

(21) Application number: **88830528.1**

(22) Date of filing: **09.12.88**

(51) Int. Cl.⁴: **G 01 R 27/02**
G 01 N 27/07, G 01 B 7/06

(30) Priority: **11.12.87 IT 957287**

(43) Date of publication of application:
**14.06.89 Bulletin 89/24**

(84) Designated Contracting States: **CH DE GB LI**

(71) Applicant: **Officine Galileo S.p.A.**
**via A.Einstein, 35**
**I-50013 Campi Bisenzio Firenze (IT)**

(72) Inventor: **Carletti, Alessandro**
**Via Leopoldo Pellas No.36**
**I-50141 Firenze (IT)**

(74) Representative: **Mannucci, Gianfranco, Dott.-Ing.**
**Ufficio Tecnico Ing. A. Mannucci Via della Scala 4**
**I-50123 Firenze (IT)**

(54) An instrument for the measurement of the "ohms per square" of metalized films.

(57) An instrument for the measurement of the thickness of the metallic layer of a under vacuum metalized film, through measurement of a resistance expressed by "ohms per square", comprising a head with circumferential concentric electrodes (1, 2, 3, 4) for feeding and measurement, and means for pressing said head against the metalized surface to by measured.

FIG.3

**Description**

## AN INSTRUMENT FOR THE MEASUREMENT OF THE "OHMS PER SQUARE" OF METALIZED FILMS

In the technology relevant to the under vacuum films metalization it is often necessary to measure the ohmic resistance of the metal layer laid on the film, with the purpose of evaluating the thickness of the metallic coating.

Usually the value of this measure is expressed by a peculiar practical unit, which is called "ohm per square".

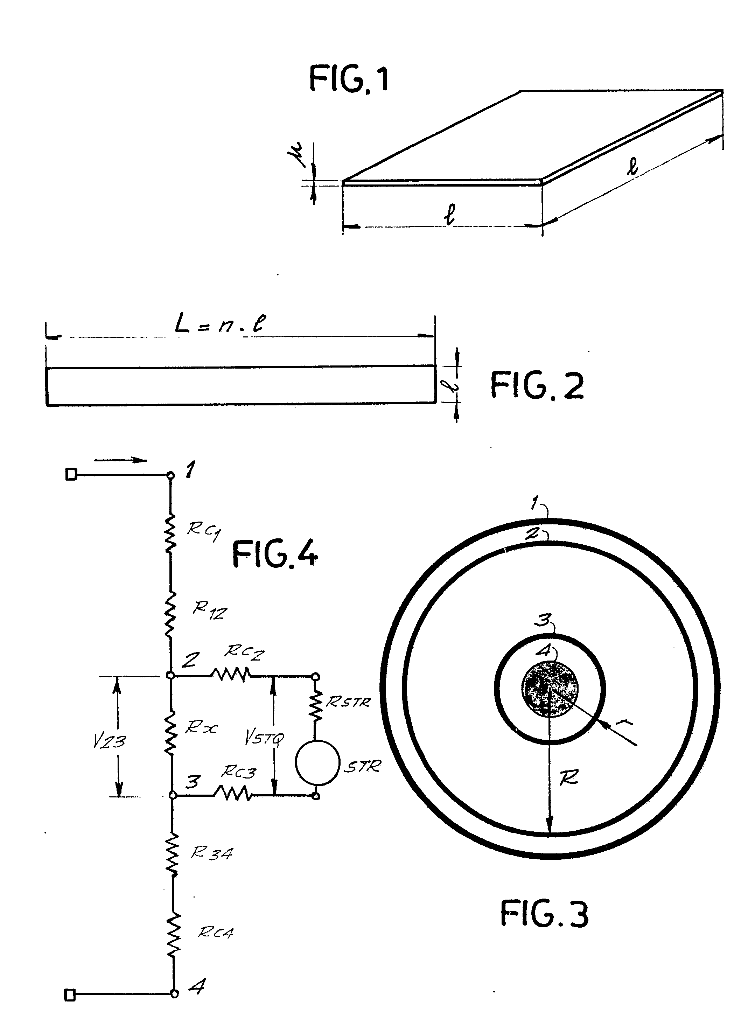

The reason of this depends on that if the resistivity of the layer of the evaporated metal could remain equal to the resistivity of the "bulk", this unit would be inversely proportional to the thickness being examined. In fact, measuring the electrical resistance of a conductor whose length is equal to the width, the following formula is valid (see Fig.1)

$$R = \rho \frac{l}{s} = \rho \frac{l}{\mu l} = \frac{\rho}{\mu}$$

wherein :

R = resistance

l = length and width

s = section $\mu$l.

$\mu$ = thickness of the layer of laid on material

$\rho$ = resistivity of the evaporated metal

In the above conditions the resistance of said conductor having a square shape is inversely proportional to the thickness.

When the thickness is extremely thin, that is with a magnitude order of hundred of Å ($10^{-10}$ meters), the above formula is no longer valid since - as previously mentioned - the resistivity $\rho$ becomes dependant on the thickness itself. Nevertheless, the value of the measurement carried out with said criterion, although it does not maintain the characteristics of a quantity that allows to know the real value of the thickness, can be used as a relative measure; in other words, coating of the same metal which show the same value of "ohms per square" are deemed as equal.

In the uaual practice this measurement is carried out (see Fig.2) by cutting out a strip of metalized film, whose length is L = nl, that is multiple of the width l (with n equal to about 10), and by measuring the resistance thereof by an ohmmeter; then the value of the measure is multiplied by the ratio width/length as follows :

$$R_o = R\frac{l}{L}$$

This method shows several drawbacks, among which the following ones are mentioned:

1) The necessity of cutting the film, which operation is not always easy and immediate with thin films;

2) The inevitable destruction of a portion of the sample being examined;

3) The necessity of a simple but scarcely practical equipment;

4) The measure is affected by a systematic error, due to the contact resistance between the instrument (ohmmeter) and the sample being examined; the influence of this error is as greater as greater is the ratio width/length and as smaller is the value of the resistance to be measured;

5) The measure obtained is an average measure on a relatively large surface.

In order to eliminate all the above mentioned drawbacks, an instrument is proposed, suitable for the measurement of the "ohms per square" value of the film, which instrument is defined and described herebelow.

Basically an instrument according to the invention for the measurement of the thickness of the metallic layer of a undervacuum metalized film, which carries out a resistance measurement expressed by "ohms per square", has small sizes and comprises a head with circumferential concentric electrodes for feeding and measurement, as well as with means to press said head against the metalized surface to be measured.

In practice the head comprises a central electrode and an external circumferential electrode for feeding, and two intermediate circumferential electrodes for the drawing of voltage for the measurement.

The instrument can comprise elastic pliers means which presses the head against a supporting surface; the film is inserted between the jaws of the pliers with the metalized surface facing the head. The head is carried by the casing of the instrument, with a pliers type lever associated thereto. As an alternative, the instrument can comprise a probe connected by an insulating cable to the instrument casing, and with the head of the electrodes suitable to be pressed against the surface to be measured.

The invention will be better understood by following the description and the accompanying drawing, which shows a practical not restricting embodiment of the invention itself. In the drawing:

Figs.1 and 2 are explanatory schemes that have been already commented:

Fig.3 shows a measurement head with four electrodes according to the invention;

Fig.4 shows an electric scheme related to the way of working of said head;

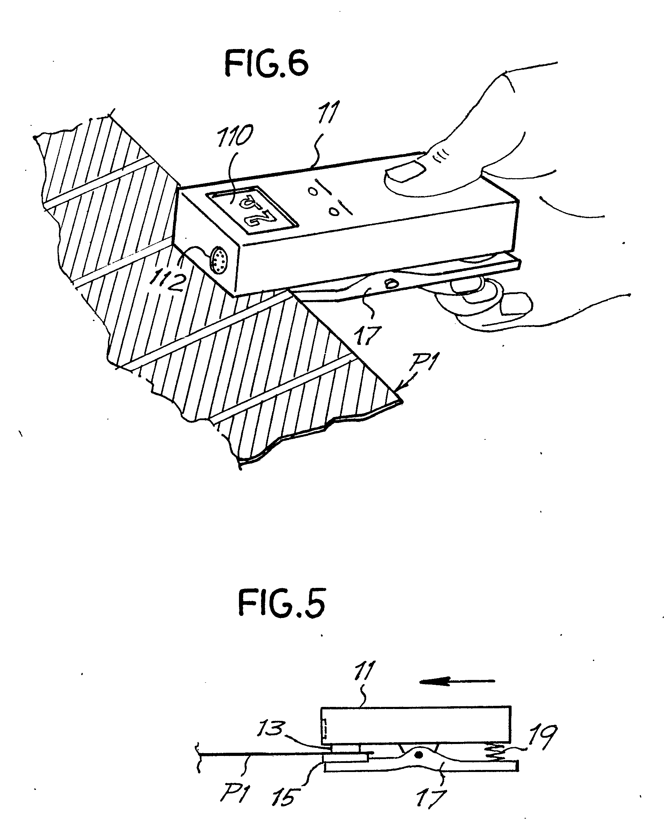

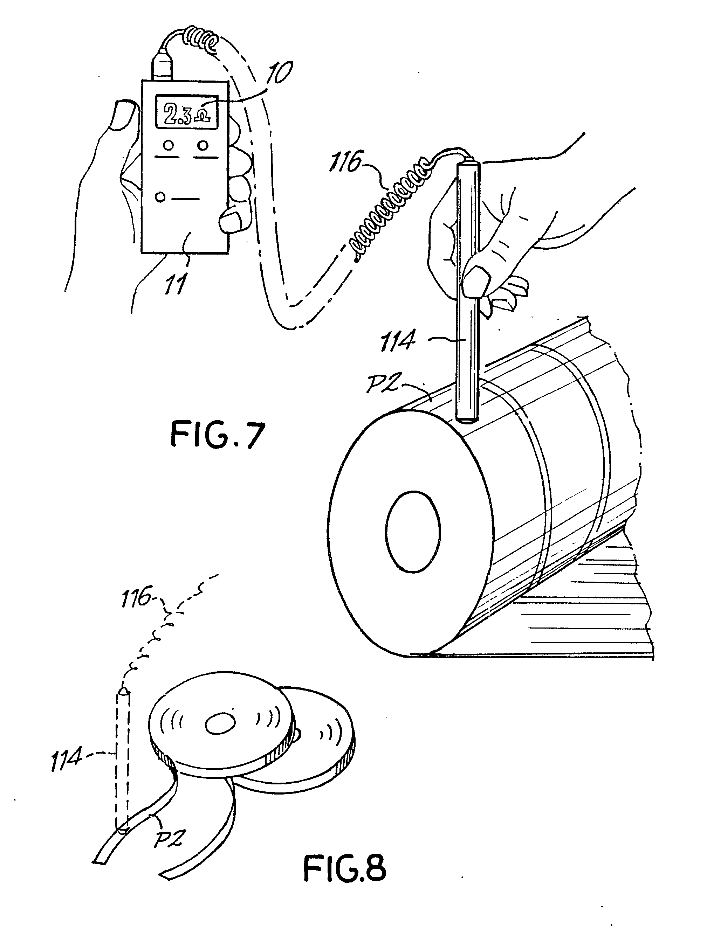

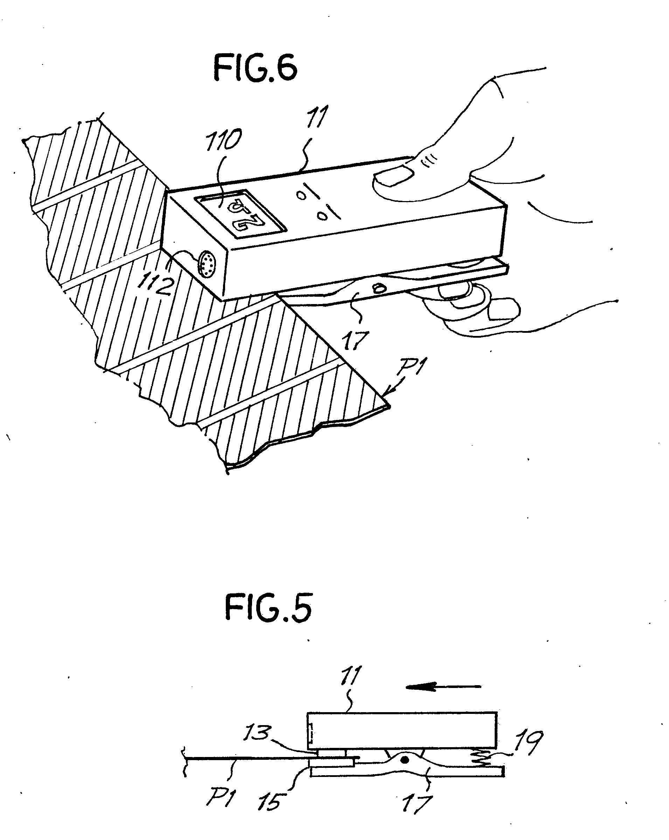

Fig.5 shows various ways for using the instrument.

According to the invention, a measurement head consists of four concentric electrodes 1, 2, 3, 4 apt to come into contact with the metallic layer of the metalized film. The electrodes 1 and 4 are the remote ones which feed the measurement head with a direct and constant current. When the head is in contact with the conductive layer of the metalized film, the circulation of such current makes a voltage V available between the intermediate electrodes 2 and 3; this voltage is measured by a high impedance voltmeter which scale can be calibrated by "ohm per square".

In the scheme of Fig.3, the current intensity is given by the formula:

$$I = \frac{2\pi}{\ln(R/r)}(mA) = 5,26mA$$

The electric scheme of Fig.4 is realized, with the following parameters:

$Rc_1$ = contact resistance between electrode 1 and the metalized film

$R_{12}$ = resistance of the metalized film surface comprised between electrodes 1 and 2

$Rx$ = resistance of the metalized film surface comprised between electrodes 2 and 3

$R_{34}$ = resistance of the metalized film surface comprised between electrodes 3 and 4

$Rc_4$ = contact resistance between electrode 4 an the metalized film

$V_{23}$ = d.c. voltage that is established on the resistance $Rx$

$I$ = d.c. feeding current

STR = measurement instrument (voltmeter) with high impedance, i.e. such an impedance that only a negligible portion of the current I circulates in the said instrument

$Rc_2$ = contact resistance between electrode 2 and the metalized film;

$Rc_3$ = contact resistance between electrode 3 and the metalized film;

$Rstr$ = instrument STR internal resistance.

Other symbols have been previously defined.

Since $(Rc_2 + Rc_3 + Rstr) \gg Rx$ (by over 4 orders of magnitude) it results:

$(Rc2 + Rc3 + Rstr)//Rx \cong Rx$

Moreover being $Rstr \gg (Rc_2 + Rc_3)$ (also in this inequality by several orders of magnitude) the measure carried out by the instrument STR will be:

$$V_{23} = V_{str} = I\frac{Rx}{Rc_1 + R_{12} + Rx + R_{34} + Rc_5}$$

with an error being lower than 0,01%.

The value, expressed by ohms per square, of the resistance $Rx$ to be measured is evaluated according to the following way:

3

$$Rx = \int_{r}^{R} \rho \frac{dr}{2\pi r \mu} = \frac{\rho}{\mu} \frac{1}{2\pi} \int_{r}^{R} \frac{dr}{r} = \frac{\rho}{\mu} \frac{1}{2\pi} \ln(R/r)$$

Since as previously remarked the ratio $\rho/\mu$ represented the value $R_o$ expressed by ohms per square, it results:

$$Rx = Ro \ \ln(R/r)/2\pi$$

$$Ro = Rx \frac{2\pi}{\ln(R/r)}$$

In the instrument in question, between the electrodes 1 and 4 a direct constant current in milliamperes is delivered, whose value is $2\pi/\ln(R/r)$, therefore the value measured in millivolt by the instrument Str expresses directly the resistance in "ohms per square" of the coating being examined.

The instrument in question permits the measurement of the "hms per square" in the technique of under vacuum metalization of thin films, with the purpose of measuring the thickness of the metal coating on the relevant support fastly and without any handling of the film (such as drawing of samples or other).

The measurement circuit is formed by a generator of constant current, that circulates on a zone of the metalized film through the proper probe with which the instrument is equipped.

An A/D converter, equipped with an high impedance differential input, gives at the output the value "read" by the probe directly in ohms per square and in a digital form on a LCD display.

A further electronic circuit permits to check the logic of the measurement, realize signallings, carry out checking tests and supply the correct feeding.

The usage of solid state components, mainly according to CMOS technology, of a converter with high integration and of a liquid crystals display allows to realize a precision instrument, with very reduced dimensions and a reduced absorption, such as to permit its feeding by a rechargeable 9V battery.

All components are contained in a plastics container 11, equipped with a probe 13 solid therewith, which permits the direct measurement on the sample of metalized film, which is interposed between the probe and a bearing 15 carried by pliers 17 urged by a spring (conventionally indicated by 19) to press the film against the probe 13.

On the front panel of case 11 there are: a display 110, especially a three digit LCD display, for the visualization of the measure in ohms per square; a led warning light (red color) to indicate that the contact between the probe electrodes and the metalized film conductive layer has been established; a led warning light (green color) for the indication of valid measure on the display; a push button for checking the regular operation of the instrument; by pushing that button, a specific value, for example 10,0 ($\pm$ 0,5) has to appear on the display.

On the sides there are both the ON/OFF switch and the tap for the possible application of a battery charger. On the top side there is a connector 112, to which a probe 114 can be applied, for the "remote" measurement, with max 2 m of a cable 116. On the rear side the pliers device 17 and the measurement head 13 are applied.

The instrument can be directly used by bearing it on the film P1, that is pressed between the opposite surfaces of members 13 and 15 through the pressure given by spring 17; as an alternative, by inserting the probe 114, the latter is directly pressed with its head against the metalized surface P2.

The limited extension of the head (about 10 mm diameter) permits to take measurements also for strips type metalizations, such as those for condensers or other.

**Claims**

1) An instrument for the measurement of the thickness of a metallic layer (P2) of an under vacuum metalized film (P1), through a measure of resistance expressed by "ohms per square", characterized in that it comprises a head with concentric circumferential electrodes (1, 2, 3, 4) for feeding and measurement, and means (17) to press said head against the metalized surface to be measured.

2) An instrument according to claim 1, characterized in that it comprises a central electrode (4) and an external circumferential electrode (1) for feeding, and two intermediate circumferential electrodes (2, 3) for the drawing of the voltage for the measurement.

3) An instrument according to claim 2, characterized in that each one of said intermediate electrodes (2, 3) is placed in the vicinity of one of the feeding electrodes (1, 4).

4) An instrument according to the preceding claims, characterized in that it comprises elastic pliers means (17) which press the head against a supporting surface (15); the film being inserted between the jaws of the pliers with the metalized surface facing the head.

5) An instrument according to claim 4, characterized in that the head is carried by the casing (11) of the instrument, to which a pliers type lever (17) is associated.

6) An instrument according to claims 1 to 3, characterized in that it comprises a probe (114) connected by a loose cable (116) to the casing (11) of the instrument, and with the electrode head suitable to be pressed against the surface to be measured.

7) An instrument according to the preceding claims, characterized in that it comprises an analogic/digital converter for the reading of the measured values.

FIG.1

FIG.2

FIG.4

FIG.3

## FIG.6

## FIG.5

FIG.7

FIG.8

# FIG.6

# FIG.5